# EUROPEAN PATENT SPECIFICATION

(11) **EP 2 945 248 B1**
(45) Date of publication and mention of the grant of the patent: **25.12.2019**
(21) Application number: 15165302.9
(22) Date of filing: 28.04.2015
(51) Int. Cl.: H02J 3/36, H02J 3/00

(54) **APPARATUS AND METHOD FOR DESIGN OF HIGH VOLTAGE DIRECT CURRENT TRANSMISSION SYSTEM**
VORRICHTUNG UND VERFAHREN ZUM ENTWURF EINES HOCHSPANNUNGS-GLEICHSTROM-ÜBERTRAGUNGSSYSTEMS
APPAREIL ET PROCÉDÉ DE CONCEPTION D'UN SYSTÈME DE TRANSMISSION HAUTE TENSION À COURANT CONTINU

(30) Priority: 13.05.2014 KR 20140057377
(43) Date of publication of application: 18.11.2015
(73) Proprietor: LSIS Co., Ltd., Anyang-si, Gyeonggi-do 431-848 (KR)
(72) Inventor: Choi, Yong Kil, Anyang-si, Gyeonggi-do 431-848 (KR)
(74) Representative: K&L Gates LLP

(56) References cited:
- CN-A- 101 694 939
- KR-B1- 101 129 158
- KR-B1- 101 146 885
- KR-B1- 101 292 856
- US-A1- 2013 041 520
- ELAHI H ET AL: "INSULATION COORDINATION PROCESS FOR HVDC CONVERTER STATIONS: PRELIMINATY AND FINAL DESIGNS", IEEE TRANSACTIONS ON POWER DELIVERY, IEEE SERVICE CENTER, NEW YORK, NY, US, vol. 4, no. 2, 1 April 1989 (1989-04-01), pages 1037-1048, XP000087345, ISSN: 0885-8977, DOI: 10.1109/61.25584

## Description

### BACKGROUND

The present disclosure relates to a high voltage direct current (HVDC) transmission system. Particularly, the present disclosure relates to an apparatus and method for a design of a HVDC transmission system.

The HVDC transmission system may convey electricity to a far distance through high voltage DC.

In general, the HVDC transmission system may transmit electricity by using an overhead line or submarine cable.

The HVDC transmission system is being widely used due to advantages such as less investment costs, unlimited cable length, and less power transmission loss.

According to the method for the design of the existing HVDC transmission, an expert designs the system according to implicit and qualitative determination on the basis of his own experiences.

However, since the HVDC transmission system is designed by the arbitrary determination of the export, a history on the operation of the existing HVDC transmission system has not been reflected, and a standardized design has not been performed. KR101292856 B1 discloses an insulation level design method of a high voltage direct current (HVDC) system to determine the satisfaction of the protection level through simulation.

ELAHI H ET AL: "INSULATION COORDINATION PROCESS FOR HVDC CONVERTER STATIONS: PRELIMINATY AND FINAL DESIGNS",IEEE TRANSACTIONS ON POWER DELIVERY, IEEE SERVICE CENTER, NEW YORK, NY, US, vol. 4, no. 2, 1 April 1989 (1989-04-01), pages 1037-1048, XP000087345,ISSN: 0885-8977, DOI: 10.1109/61.25584 discloses that an insulation design of a HVDC system is based on the knowledge of known insulation designs.

### SUMMARY

The invention is defined by the independent claims. The dependent claims define advantageous embodiments.

Embodiments provide an apparatus and method for design of an HVDC transmission system, which is capable of reflecting a history on an operation of an existing HVDC transmission system and enabling a standardized design.

The details of one or more embodiments are set forth in the accompanying drawings and the description below. Other features will be apparent from the description and drawings, and from the claims.

### BRIEF DESCRIPTION OF THE DRAWINGS

Fig. 1 is a view of a high voltage direct current (HVDC) transmission system.
Fig. 2 is a view of a monopolar-type HVDC transmission system.
Fig. 3 is a view of a bipolar-type HVDC transmission system.
Fig. 4 is a view illustrating connection between a transformer and a three-phase valve bridge.
Fig. 5 is a block diagram of an apparatus for a design of the HVDC transmission system.
Fig. 6 is a block diagram of a method for the design of the HVDC transmission system.
Fig. 7 is a flowchart illustrating an operation of an HVDC transmission system design unit of the apparatus for the design of the HVDC transmission system.
Fig. 8 is a block diagram illustrating an apparatus for an insulation design of the HVDC transmission system.
Fig. 9 is a flowchart illustrating an operation method of the insulation design apparatus of the HVDC transmission system.

### DETAILED DESCRIPTION OF THE EMBODIMENTS

Reference will now be made in detail to the embodiments of the present disclosure, examples of which are illustrated in the accompanying drawings.

An electric device for an electric vehicle according to an embodiment will be described in detail with reference to the accompanying drawings.

Hereinafter, embodiments of the present disclosure will be described in more detail with reference to the accompanying drawings. Furthermore, terms, such as a "part", a "module" ad a "unit", are used for convenience of description, and they do not have different meanings or functions in themselves.

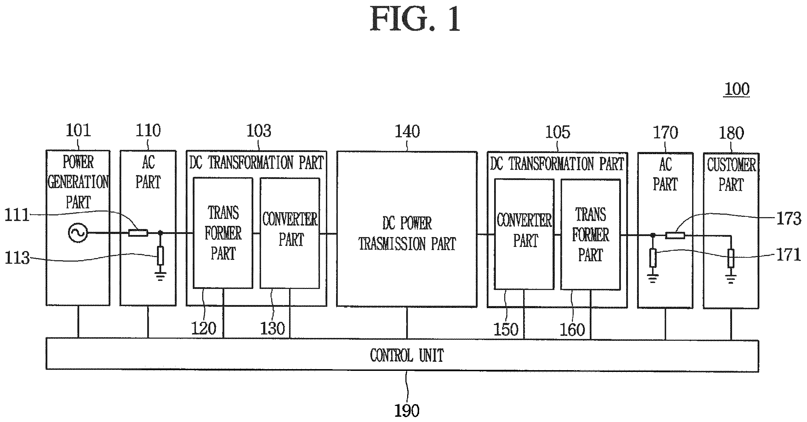

Fig. 1 is a view of a high voltage direct current (HVDC) transmission system according to an embodiment.

Referring to Fig. 1, an HVDC transmission system 100 according to an embodiment includes a power generation part 101, a transmission-side alternating current (AC) part 110, a transmission-side transformation part 103, a direct current (DC) power transmission part 140, a customer-side DC transformation part 105, a customer-side AC part 170, a customer part 180, and a control part 190. The transmission-side DC transformation part 103 includes a transmission-side transformer part 120, and a transmission-side AC-DC converter part 130. The customer-side DC transformation part 105 includes a customer-side DC-AC converter part 150, and a customer-side transformer part 160.

The power generation part 101 generates a three-phase AC power. The power generation part 101 may include a plurality of power generating plants.

The transmission-side AC part 110 transmits the three-phase AC power generated by the generation part 101 to a DC power transformation substation including the transmission-side transformer part 120 and the transmission-side AC-DC converter part 130.

The transmission-side transformer part 110 isolates the transmission-side AC part 110 from the transmission-side AC-DC converter part 130 and the DC power transmission part 140.

The transmission-side AC-DC converter part 130 converts the three-phase AC power corresponding to an output of the transmission-side transformer part 120 into a DC power.

The DC power transmission part 140 transfers the transmission-side DC power to a customer-side.

The customer-side DC-AC converter part 150 converts the DC power transmitted by the DC power transmission part 140 into a three-phase AC power.

The customer-side transformer part 160 isolates the customer-side AC part 170 from the customer-side DC-AC converter part 150 and the DC power transmission part 140.

The customer-side AC part 170 provides the three-phase AC power corresponding to an output of the customer-side transformer part 160 to the customer part 180.

The control part 190 controls at least one of the power generation part 101, the transmission-side AC part 110, the transmission-side DC transformation part 103, the DC power transmission part 140, the customer-side DC transformation part 105, the customer-side AC part 170, the customer part 180, the transmission-side AC-DC converter part 130, and the customer-side DC-AC converter part 150. Particularly, the control part 190 may control turn-on and turn-off timings of a plurality of valves within the transmission-side AC-DC converter part 130 and the customer-side DC-AC converter part 150. Here, each of the valves may be a thyristor or an insulated gate bipolar transistor (IGBT).

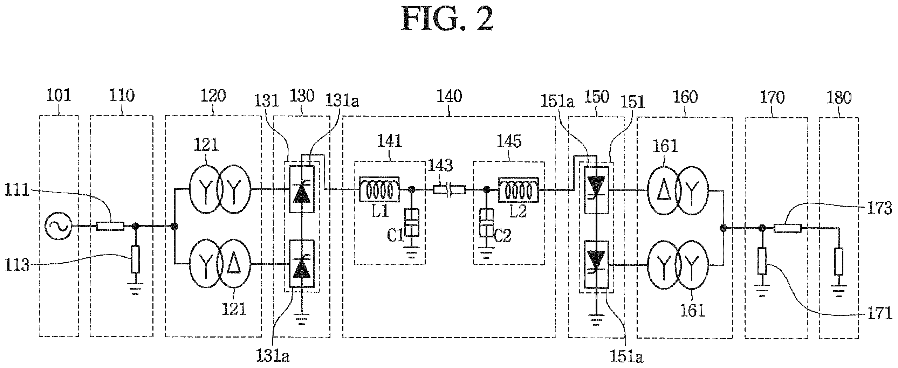

Fig. 2 is a view of a monopolar-type HVDC transmission system.

Particularly, Fig. 2 illustrates a system that transmits a DC power having a single pole. Hereinafter, it is assumed that the single pole is a positive pole, but is not limited thereto.

The transmission-side AC part 110 includes an AC transmission line 111 and an AC filter 113.

The AC power transmission line 111 transmits the three-phase AC power generated by the generation part 101 to the transmission-side DC transformation part 103.

The AC filter 113 removes remaining frequency components except for a frequency component that is used by the DC transformation part 103 from the transferred three-phase AC power.

The transmission-side transformer part 120 includes at least one transformer 121 for the positive pole. For the positive pole, the transmission-side AC-DC converter part 130 includes an AC-positive pole DC converter 131 that generates a positive pole DC power, and the AC-positive pole DC converter 131 includes at least one three-phase valve bridge 131a corresponding to the at least one transformer 121.

When one three-phase valve bridge 131a is used for the positive pole, the AC-positive pole DC converter 131 may generate a positive pole DC power having 6 pulses by using the AC power. Here, a primary coil and a secondary coil of one transformer 121 may have Y-Y connection or Y-Δ connection.

When two three-phase valve bridges 131a are used, the AC-positive pole DC converter 131 may generate a positive pole DC power having 12 pulses by using the AC power. Here, a primary coil and a secondary coil of one of the two transformers 121 may have Y-Y connection, and a primary coil and a secondary coil of the other of the two transformers 121 may have Y-Δ connection.

When three three-phase valve bridges 131a are used, the AC-positive pole DC converter 131 may generate a positive pole DC power having 18 pulses by using the AC power. The more the number of pulses of the positive pole DC power increases, the more a filter price may decrease.

The DC power transmission part 140 includes a transmission-side positive pole DC filter 141, a positive pole DC power transmission line 143, and a customer-side positive pole DC filter 145.

The transmission-side positive pole DC filter 141 includes an inductor L1 and a capacitor C1 and performs DC filtering on the positive pole DC power output by the AC-positive pole DC converter 131.

The positive pole DC power transmission line 143 has one DC line for transmitting the positive pole DC power, and the earth may be used as a current feedback path. At least one switch may be disposed on the DC line.

The customer-side negative pole DC filter 145 includes an inductor L2 and a capacitor C2 and performs DC filtering on the positive pole DC power transferred through the positive pole DC power transmission line 143.

The customer-side DC-AC converter part 150 includes a positive pole DC-AC converter 151 and at least one three-phase valve bridge 151a.

The customer-side transformer part 160 includes, for the positive pole, at least one transformer 161 corresponding to at least one three-phase valve bridge 151a.

When one three-phase valve bridge 151a is used, the positive pole DC-AC converter 151 may generate an AC power having 6 pulses by using the positive pole DC power. Here, a primary coil and a secondary coil of one transformer 161 may have Y-Y connection or Y-Δ connection.

When two three-phase valve bridges 151a are used, the positive pole DC-AC converter 151 may generate an AC power having 12 pulses by using the positive pole DC power. Here, a primary coil and a secondary coil of one of the two transformers 161 may have Y-Y connection, and a primary coil and a secondary coil of the other of the two transformers 161 may have Y-Δ connection.

When three three-phase valve bridges 151a are used, the positive pole DC-AC converter 151 may generate an AC power having 18 pulses by using the positive pole DC power. The more the number of pulses of the AC power increases, the more the filter price may decrease.

The customer-side AC part 170 includes an AC filter 171 and an AC power transmission line 173.

The AC filter 171 removes remaining frequency components except for a frequency component (for example, 60Hz) used by the customer part 180 from the AC power generated by the customer-side DC transformation part 105.

The AC power transmission line 173 transmits the filtered AC power to the customer part 180.

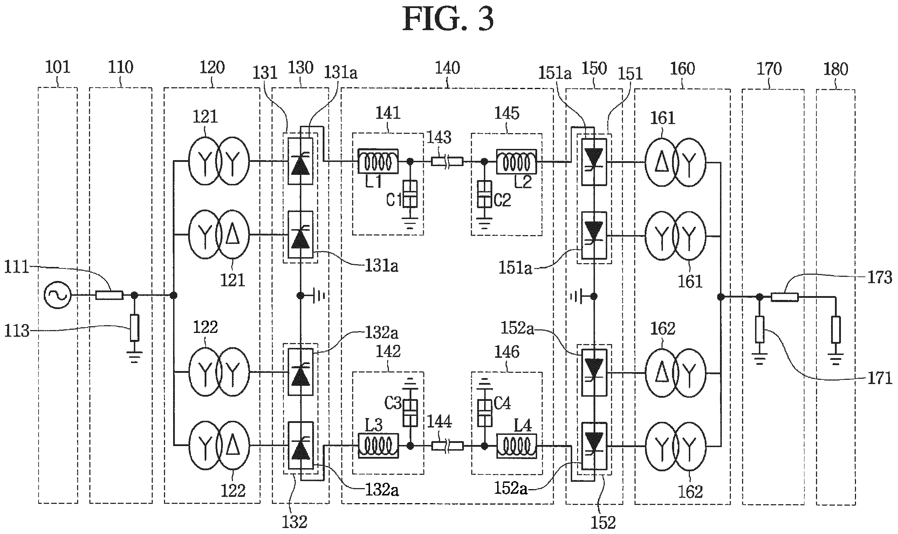

Fig. 3 is a view of a bipolar-type HVDC transmission system.

Particularly, Fig. 3 illustrates a system that transmits a DC power having two poles. Hereinafter, it is assumed that the two poles are a positive pole and a negative pole, but is not limited thereto.

The transmission-side AC part 110 includes an AC transmission line 111 and an AC filter 113.

The AC power transmission line 111 transmits the three-phase AC power generated by the generation part 101 to the transmission-side transformation part 103.

The AC filter 113 removes remaining frequency components except for a frequency component used by the transformation part 103 from the transferred three-phase AC power.

The transmission-side transformer part 120 includes at least one transformer 121 for the positive pole and at least one transformer 122 for the negative pole. The transmission-side AC-DC converter part 130 includes an AC-positive pole DC converter 131 that generates a positive pole DC power and an AC-negative pole DC converter 132 that generates a negative pole DC power. The AC-positive pole DC converter 131 includes at least one three-phase valve bridge 131a corresponding to the at least one transformer 121 for the positive pole. The AC-negative pole DC converter 132 includes at least one three-phase valve bridge 132a corresponding to the at least one transformer 122 for the negative pole.

When one three-phase valve bridge 131a is used for the positive pole, the AC-positive pole DC converter 131 may generate a positive pole DC power having 6 pulses by using the AC power. Here, a primary coil and a secondary coil of one transformer 121 may have Y-Y connection or Y-Δ connection.

When two three-phase valve bridges 131a are used for the positive pole, the AC-positive pole DC converter 131 may generate a positive pole DC power having 12 pulses by using the AC power. Here, a primary coil and a secondary coil of one of the two transformers 121 may have Y-Y connection, and a primary coil and a secondary coil of the other of the two transformers 121 may have Y-Δ connection.

When three three-phase valve bridges 131a are used for the positive pole, the AC-positive pole DC converter 131 may generate a positive pole DC power having 18 pulses by using the AC power. The more the number of pulses of the positive pole DC power increases, the more the filter price may decrease.

When one three-phase valve bridge 132a is used for the negative pole, the AC-negative pole DC converter 132 may generate a negative pole DC power having 6 pulses. Here, a primary coil and a secondary coil of one transformer 122 may have Y-Y connection or Y-Δ connection.

When two three-phase valve bridges 132a are used for the negative pole, the AC-negative pole DC converter 132 may generate a negative pole DC power having 12 pulses. Here, a primary coil and a secondary coil of one of the two transformers 122 may have Y-Y connection, and a primary coil and a secondary coil of the other of the two transformers 122 may have Y-Δ connection.

When three three-phase valve bridges 132a are used for the negative pole, the AC-negative pole DC converter 132 may generate a negative pole DC power having 18 pulses. The more the number of pulses of the negative pole DC power increases, the more the filter price may decrease.

The DC power transmission part 140 includes a transmission-side positive pole DC filter 141, a transmission-side negative pole DC filter 142, a positive pole DC power transmission line 143, a negative pole DC power transmission line 144, a customer-side positive pole DC filter 145, and a customer-side negative pole DC filter 146.

The transmission-side positive pole DC filter 141 includes an inductor L1 and a capacitor C1 and performs DC filtering on the positive pole DC power output by the AC-positive pole DC converter 131.

The transmission-side negative pole DC filter 142 includes an inductor L3 and a capacitor C3 and performs DC filtering on the negative pole DC power output by the AC-negative pole DC converter 132.

The positive pole DC power transmission line 143 has one DC line for transmitting the negative pole DC power, and the earth may be used as a current feedback path. At least one switch may be disposed on the DC line.

The negative pole DC power transmission line 144 has one DC line for transmitting the negative pole DC power, and the earth may be used as a current feedback path. At least one switch may be disposed on the DC line.

The customer-side negative pole DC filter 145 includes an inductor L2 and a capacitor C2 and performs DC filtering on the positive pole DC power transferred through the positive pole DC power transmission line 143.

The customer-side negative pole DC filter 146 includes an inductor L4 and a capacitor C4 and performs DC filtering on the negative pole DC power transferred through the negative pole DC power transmission line 144.

The customer-side DC-AC converter part 150 includes a positive pole DC-AC converter 151 and a negative pole DC-AC converter 152. The positive pole DC-AC converter 151 includes at least one three-phase valve bridge 151a, and the negative pole DC-AC converter 152 includes at least one three-phase valve bridge 152a.

The customer-side transformer part 160 includes, for the positive pole, at least one transformer 161 corresponding to the at least one three-phase valve bridge 151a and, for the negative pole, at least one transformer 162 corresponding to the at least one three-phase valve bridge 152a.

When one three-phase valve bridge 151a is used for the positive pole, the positive pole DC-AC converter 151 may generate an AC power having 6 pulses by using the positive pole DC power. Here, a primary coil and a secondary coil of one transformer 161 may have Y-Y connection or Y-Δ connection.

When two three-phase valve bridges 151a are used for the positive pole, the positive pole DC-AC converter 151 may generate an AC power having 12 pulses by using the positive pole DC power. Here, a primary coil and a secondary coil of one of the two transformers 161 may have Y-Y connection, and a primary coil and a secondary coil of the other of the two transformers 161 may have Y-Δ connection.

When three three-phase valve bridges 151a are used for the positive pole, the positive pole DC-AC converter 151 may generate an AC power having 18 pulses by using the positive pole DC power. The more the number of pulses of the AC power increases, the more the filter price may decrease.

When one three-phase valve bridge 152a is used for the negative pole, the negative pole DC-AC converter 152 may generate an AC power having 6 pulses by using the negative pole DC power. Here, a primary coil and a secondary coil of one transformer 162 may have Y-Y connection or Y-Δ connection.

When two three-phase valve bridges 152a is used for the negative pole, the negative pole DC-AC converter 152 may generate an AC power having 12 pulses by using the negative pole DC power. Here, a primary coil and a secondary coil of one of the two transformers 162 may have Y-Y connection, and a primary coil and a secondary coil of the other of the two transformers 162 may have Y-Δ connection.

When three three-phase valve bridges 152a is used for the negative pole, the negative pole DC-AC converter 152 may generate an AC power having 18 pulses by using the negative pole DC power. The more the number of pulses of the AC power increases, the more the filter price may decrease.

The customer-side AC part 170 includes an AC filter 171 and an AC power transmission line 173.

The AC filter 171 removes remaining frequency components except for a frequency component (for example, 60Hz) used by the customer part 180 from the AC power generated by the customer-side DC transformation part 105.

The AC power transmission line 173 transmits the filtered AC power to the customer part 180.

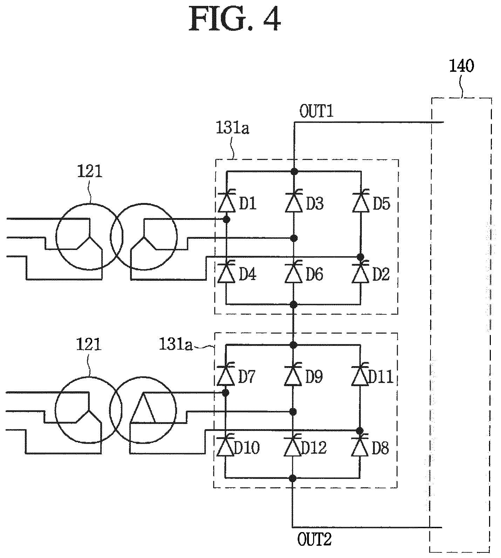

Fig. 4 is a view illustrating connection between the transformer and the three-phase valve bridge.

Particularly, Fig. 4 illustrates the connection between the two transformers 121 for the positive pole and the two three-phase valve bridges 131a for the positive pole. Since the connection between the two transformers 122 for the negative pole and the two three-phase valve bridges 132a for the negative pole, the connection between the two transformers 161 for the positive pole and the two three-phase valve bridges 151a for the positive pole, the connection between the two transformers 162 for the negative pole and the two three-phase valve bridges 152a for the negative pole, the connection between the one transformer 121 for the positive pole and the one three-phase valve bridge 131a for the positive pole, and the connection between the one transformer 161 for the positive pole and the one three-phase valve bridge 151a for the positive pole could be easily derived from Fig. 4, their drawings and descriptions thereof will be omitted.

In Fig. 4, the transformer 121 having the Y-Y connection is called an upper transformer, the transformer 121 having the Y-Δ connection is called a lower transformer, the three-phase valve bridge 131a connected to the upper transformer is called an upper three-phase valve bridges, and the three-phase valve bridges 131a connected to the lower transformer is called a lower three-phase valve bridges.

The upper three-phase valve bridges and the lower three-phase valve bridges have two output terminals outputting a DC power, i.e., a first output terminal OUT1 and a second output terminal OUT2.

The upper three-phase valve bridge includes six valves D1 to D6, and the lower three-phase valve bridges include six valves D7 to D12.

The valve D1 has a cathode connected to the first output terminal OUT1 and an anode connected to a second terminal of the secondary coil of the upper transformer.

The valve D2 has a cathode connected to the anode of the valve D5 and an anode connected to the anode of the valve D6.

The valve D3 has a cathode connected to the first output terminal OUT1 and an anode connected to a second terminal of the secondary coil of the upper transformer.

The valve D4 has a cathode connected to the anode of the valve D1 and an anode connected to the anode of the valve D6.

The valve D5 has a cathode connected to the first output terminal OUT1 and an anode connected to a third terminal of the secondary coil of the upper transformer.

The valve D6 has a cathode connected to the anode of the valve D3.

The valve D7 has a cathode connected to the anode of the valve D6 and an anode connected to a first terminal of the secondary coil of the lower transformer.

The valve D8 has a cathode connected to the anode of the valve D11 and an anode connected to a second output terminal OUT2.

The valve D9 has a cathode connected to the anode of the valve D6 and an anode connected to a second terminal of the secondary coil of the lower transformer.

The valve D10 has a cathode connected to the anode of the valve D7 and an anode connected to the second output terminal OUT2.

The valve D11 has a cathode connected to the anode of the valve D6 and an anode connected to a third terminal of the secondary coil of the lower transformer.

The valve D12 has a cathode connected to the anode of the valve D9 and an anode connected to the second output terminal OUT2.

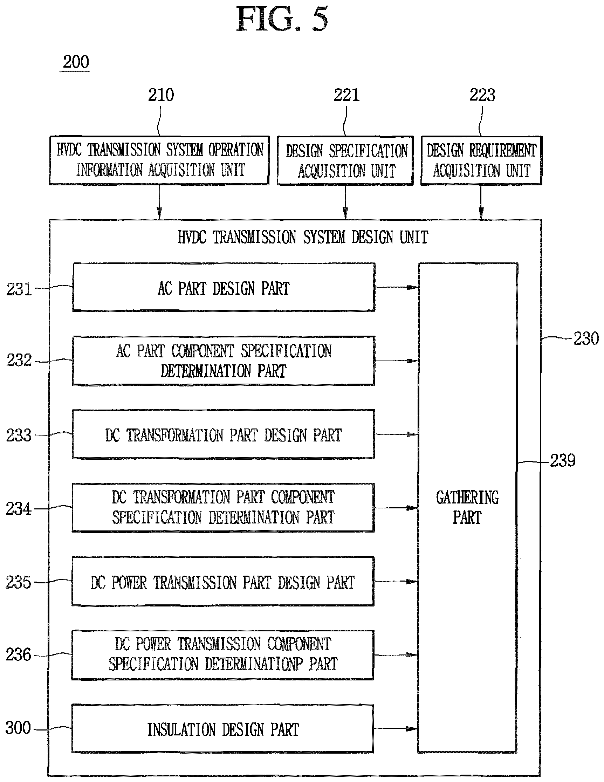

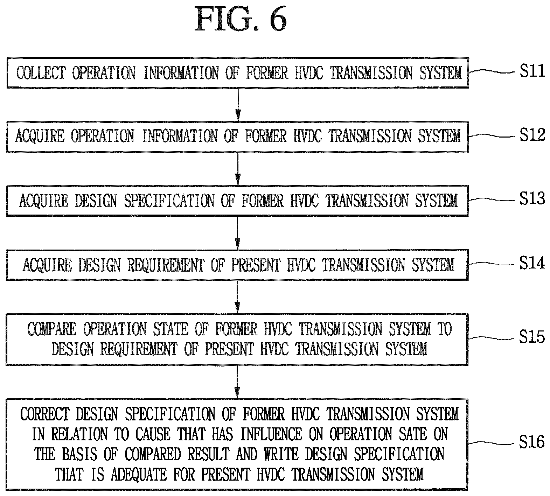

An apparatus for a design of the HVDC transmission system will now be described with reference to Figs. 5 and 6.

Fig. 5 is a block diagram of an apparatus for a design of the HVDC transmission system.

An apparatus 200 for a design of the HVDC transmission system includes an HVDC transmission system operation information acquisition unit 210, a design specification acquisition unit 221, a design requirement acquisition unit 223, and an HVDC transmission system design unit 230. The HVDC transmission system design unit 230 includes an AC transformation part design part 231, an AC part component specification determination part 232, a DC part design part 233, a DC transformation part component specification determination part 234, a DC power transmission part design part 235, a DC power transmission part component specification determination part 236, an insulation design part 300, and a gathering part 239.

The HVDC transmission system operation information acquisition unit 210 acquires operation information of a former HVDC transmission system from a control part 190 of the former HVDC transmission system.

The design specification acquisition unit 221 acquires a design specification of the former HVDC transmission system.

The design requirement acquisition unit 223 acquires a design requirement of the present HVDC transmission system.

The HVDC transmission system design unit 230 designs the present HVDC transmission system on the basis of the design specification of the former HVDC transmission system, the operation information of the former HVDC transmission system, and the design requirement of the present HVDC transmission system.

The AC transformation part design part 231 designs structures of the AC parts 110 and 170 of the present HVDC transmission system on the basis of the operation information of the former HVDC transmission system and the design requirement of the present HVDC transmission system.

The AC part component specification determination part 232 determines specifications of the components within the AC parts 110 and 170 of the present HVDC transmission system on the basis of the operation information of the former HVDC transmission system and the design requirement of the present HVDC transmission system.

The DC transformation part design part 233 designs structures of DC transformation parts 103 and 105 of the present HVDC transmission system on the basis of the operation information of the former HVDC transmission system and the design requirement of the present HVDC transmission system.

The DC transformation part component specification determination part 234 determines specifications of components within the DC transformation parts 103 and 105 of the present HVDC transmission system on the basis of the operation information of the former HVDC transmission system and the design requirement of the present HVDC transmission system.

The DC power transmission part design part 235 designs structures of a DC power transmission part 140 of the present HVDC transmission system on the basis of the operation information of the former HVDC transmission system and the design requirement of the present HVDC transmission system.

The DC power transmission part component specification determination part 236 determines specifications of components within a DC power transmission part 140 of the present HVDC transmission system on the basis of the operation information of the former HVDC transmission system and the design requirement of the present HVDC transmission system.

The insulation design part 300 performs an insulation design of the present HVDC transmission system on the basis of the operation information of the former HVDC transmission system and the design requirement of the present HVDC transmission system.

The gathering part 239 gathers the structures of the AC parts 110 and 170, the specifications of the components within the AC parts 110 and 170, the structures of the DC transformation parts 103 and 105, the specifications of the components within the DC transformation parts 103 and 105, the structure of the DC power transmission part 140, the specifications of the components within the DC power transmission part 140, and the insulation design of the present HVDC transmission system to design the present HVDC transmission system.

Fig. 6 is a block diagram of a method for the design of the HVDC transmission system.

In operation S11, a control part 190 of a former HVDC transmission system collects operation information of the former HVDC transmission system. Here, the operation information may include information with respect to an operation state and operation state cause information with respect to causes that have an influence on the operation state. The operation state information may include information with respect to an available rate, information with respect to an operation time, and information with respect to a lifecycle of the former HVDC transmission system. The operation state cause information may include information with respect to a type of breakdown, information with respect to a cause of the breakdown, information with respect to a cause that has an influence on the available rate, and information with respect to a cause that has an influence on the lifecycle.

In operation S12, the HVDC transmission system operation information acquisition unit 210 acquires operation information of a former HVDC transmission system from a control part 190 of the former HVDC transmission system.

In operation S13, the design specification acquisition unit 221 acquires a design specification of the former HVDC transmission system. Here, the design specification of the former HVDC transmission system may include a design structure of the AC part of the former HVDC transmission system, a component specification of the AC part of the former HVDC transmission system, a design structure of the DC transformation part of the former HVDC transmission system, a component specification of the DC transformation part of the former HVDC transmission system, a design structure of the DC power transmission part of the former HVDC transmission system, and a component specification of the DC power transmission part of the former HVDC transmission system.

In operation S14, the design requirement acquisition unit 223 acquires a design requirement of the present HVDC transmission system. Here, the design requirement of the present HVDC transmission system may include information with respect to an available rate, information with respect to an operation time, and information with respect to a lifecycle of the present HVDC transmission system.

In operation S15, the HVDC transmission system design unit 230 compares the operation state of the former HVDC transmission system to the design requirement of the present HVDC transmission system.

The HVDC transmission system design unit 230 corrects the design specification of the former HVDC transmission system in relation to the cause that has an influence on the operation state on the basis of the compared result to write a design specification that is adequate for the design requirement of the present HVDC transmission system.

Particularly, if the design requirement of the present HVDC transmission system requires a requirement that is higher than the operation state of the former HVDC transmission system, the HVDC transmission system design unit 230 may increase the design specification of the former HVDC transmission system in relation to the operation state cause by a difference between the design requirement of the current HVDC transmission system and the operation state of the former HVDC transmission system to write a design specification that is adequate for the design requirement of the present HVDC transmission system.

Particularly, if the design requirement of the present HVDC transmission system requires a requirement that is lower than the operation state of the former HVDC transmission system, the HVDC transmission system design unit 230 may decrease the design specification of the former HVDC transmission system in relation to the operation state cause by a difference between the design requirement of the current HVDC transmission system and the operation state of the former HVDC transmission system to write a design specification that is adequate for the design requirement of the present HVDC transmission system.

For example, if the design specification of the former HVDC transmission system has two DC power transmission paths, the operation state of the former HVDC transmission system has an available rate of about 98%, the operation analysis information indicates an error of the DC power transmission path that is a main cause of decreasing of the available rate, and the design requirement of the present HVDC transmission system requires a n available rate of about 99%, the HVDC transmission system design unit 230 may write the design specification of the present HVDC transmission system so that the current HVDC transmission system includes three DC power transmission paths or increase the specifications of the components in the two DC power transmission path.

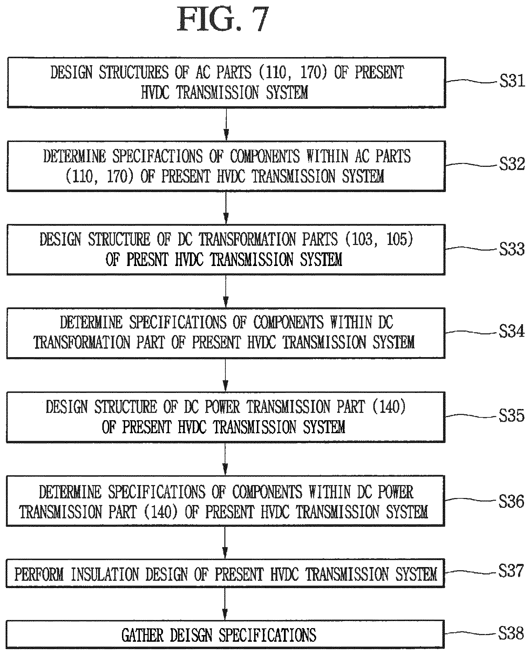

Fig. 7 is a flowchart illustrating an operation of an HVDC transmission system design unit of the apparatus for the design of the HVDC transmission system.

In operation S31, the AC transformation part design part 231 designs structures of the AC parts 110 and 170 of the present HVDC transmission system on the basis of the operation information of the former HVDC transmission system and the design requirement of the present HVDC transmission system. The AC transformation part design part 231 may correct the design structure of the AC part of the former HVDC transmission system in relation to the cause that has an influence on the operation state on the basis of the comparison between the operation state information of the former HVDC transmission system and the design requirement of the present HVDC transmission system to write a design specification with respect to the structures of the AC parts 110 and 170 of the present HVDC transmission system.

In operation S32, the AC part component specification determination part 232 determines specifications of the components within the AC parts 110 and 170 of the present HVDC transmission system on the basis of the operation information of the former HVDC transmission system and the design requirement of the present HVDC transmission system. The AC part component specification determination part 232 may correct the component specification of the AC part of the former HVDC transmission system in relation to the cause that has an influence on the operation state on the basis of the comparison between the operation state information of the former HVDC transmission system and the design requirement of the present HVDC transmission system to write specifications of the components within the AC parts 110 and 170 of the present HVDC transmission system.

In operation S33, the DC transformation part design part 233 designs structures of DC transformation parts 103 and 105 of the present HVDC transmission system on the basis of the operation information of the former HVDC transmission system and the design requirement of the present HVDC transmission system. The DC transformation part design part 233 may correct the design structure of the DC transformation part of the former HVDC transmission system in relation to the cause that has an influence on the operation state on the basis of the comparison between the operation state information of the former HVDC transmission system and the design requirement of the present HVDC transmission system to write a design specification with respect to the structures of the DC transformation parts 103 and 105 of the present HVDC transmission system.

In operation S34, the DC transformation part component specification determination part 234 determines specifications of components within the DC transformation parts 103 and 105 of the present HVDC transmission system on the basis of the operation information of the former HVDC transmission system and the design requirement of the present HVDC transmission system. The DC transformation part component specification determination part 234 may correct the component specification of the DC transformation part of the former HVDC transmission system in relation to the cause that has an influence on the operation state on the basis of the comparison between the operation state information of the former HVDC transmission system and the design requirement of the present HVDC transmission system to write specifications of the components within the DC transformation parts 103 and 105 of the present HVDC transmission system.

In operation S35, the DC power transmission part design part 235 designs structures of a DC power transmission part 140 of the present HVDC transmission system on the basis of the operation information of the former HVDC transmission system and the design requirement of the present HVDC transmission system. The DC power transmission part design part 235 may correct the design structure of the DC power transmission part of the former HVDC transmission system in relation to the cause that has an influence on the operation state on the basis of the comparison between the operation state information of the former HVDC transmission system and the design requirement of the present HVDC transmission system to write a design specification with respect to the structures of the DC power transmission part 140 of the present HVDC transmission system.

In operation S36, the DC power transmission part component specification determination part 236 determines specifications of components within a DC power transmission part 140 of the present HVDC transmission system on the basis of the operation information of the former HVDC transmission system and the design requirement of the present HVDC transmission system. The DC power transmission part component specification determination part 236 may correct the component specification of the DC power transmission part of the former HVDC transmission system in relation to the cause that has an influence on the operation state on the basis of the comparison between the operation state information of the former HVDC transmission system and the design requirement of the present HVDC transmission system to write specifications of the components within the DC power transmission part 140 of the present HVDC transmission system.

In operation S37, the insulation design part 300 performs an insulation design of the present HVDC transmission system on the basis of the operation information of the former HVDC transmission system and the design requirement of the present HVDC transmission system.

The insulation design part 300 performs an insulation design of the present HVDC transmission system on the basis of the operation information of the former HVDC transmission system and the design requirement of the present HVDC transmission system.

In operation S38, the gathering part 239 gathers the structures of the AC parts 110 and 170, the specifications of the components within the AC parts 110 and 170, the structures of the DC transformation parts 103 and 105, the specifications of the components within the DC transformation parts 103 and 105, the structure of the DC power transmission part 140, the specifications of the components within the DC power transmission part 140, and the insulation design of the present HVDC transmission system to design the present HVDC transmission system.

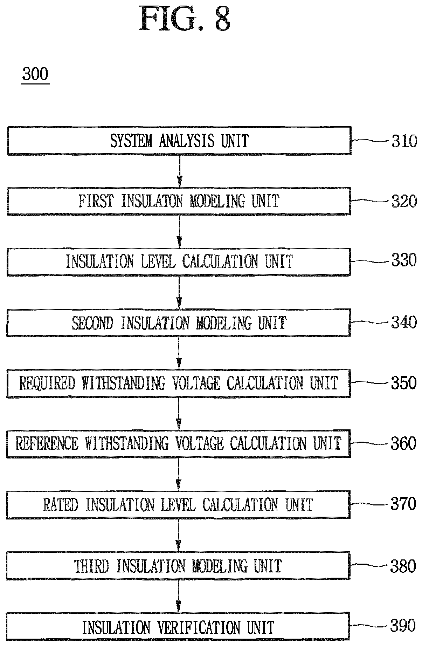

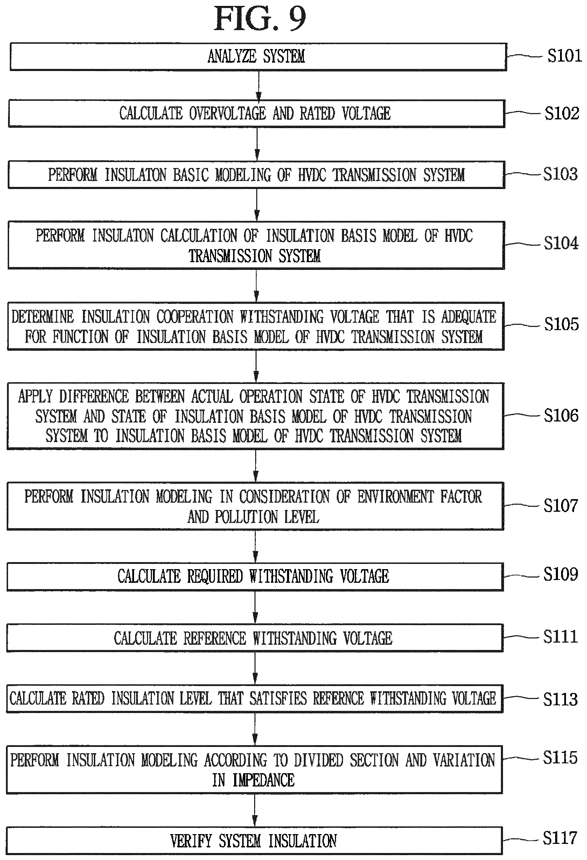

A method for an insulation design of the HVDC transmission system will be described with reference to Figs. 8 and 9.

Fig. 8 is a block diagram illustrating an apparatus for an insulation design of the HVDC transmission system.

Referring to Fig. 8, an insulation design part 300 of the HVDC transmission system 100 includes a system analysis unit 310, a first insulation modeling unit 320, an insulation level calculation unit 330, a second insulation modeling unit 340, a required withstanding voltage calculation unit 350, a reference withstanding voltage calculation unit 360, a rated insulation level calculation unit 370, a third insulation modeling unit 380, and an insulation verification unit 390.

The system analysis unit 310 analyzes the HVDC transmission system 100 in operation S101 to calculate an overvoltage and rated voltage of the HVDC transmission system 100.

The first insulation modeling unit 320 may model the HVDC transmission system 100 on the basis of the calculated overvoltage and rated voltage to generate an insulation basis model of the HVDC transmission system 100.

The insulation level calculation unit 330 performs insulation calculation of the insulation basic model of the HVDC transmission system 100 in operation S104 to determine an insulation cooperation withstanding voltage that is adequate for performing a function of the insulation basic model of the HVDC transmission system 100.

The second insulation modeling unit 340 applies a difference between an actual operation state of the HVDC transmission system 100 and a state of the insulation basic model of the HVDC transmission system 100 to the insulation basic model of the HVDC transmission system 100 in operation S106 to correct the insulation basic model of the HVDC transmission system 100, thereby generating an insulation model of the HVDC transmission system 100.

The required withstanding voltage calculation unit 350 calculates a required withstanding voltage of the insulation model of the HVDC transmission system 100.

The reference withstanding voltage calculation unit 360 calculates a reference withstanding voltage of the insulation model of the HVDC transmission system 100 from the required withstanding voltage of the insulation model of the HVDC transmission system 100.

The rated insulation level calculation unit 370 calculates a rated insulation level that satisfies the reference withstanding voltage of the insulation model of the HVDC transmission system 100.

The third insulation modeling unit 380 corrects the insulation model of the HVDC transmission system 100 on the basis of a variation in impedance in a divided section of the HVDC transmission system 100 to generate a corrected insulation model.

The insulation verification unit 390 verifies whether the corrected insulation model of the HVDC transmission system 100 satisfies the required withstanding voltage.

Fig. 9 is a flowchart illustrating an operation method of the insulation design apparatus of the HVDC transmission system.

The system analysis unit 310 analyzes the HVDC transmission system 100 in operation S101 to calculate an overvoltage and rated voltage in operation S102. The system analysis unit 310 may analyze the HVDC transmission system 100 to calculate the overvoltage and rated voltage on the basis of at least one of a classified stress voltage, a calculated overvoltage protection level, and an insulation property.

The first insulation modeling unit 320 models the HVDC transmission system 100 on the calculated overvoltage and rated voltage to generate an insulation basis model of the HVDC transmission system 100 in operation S103.

The insulation level calculation unit 330 performs insulation calculation of the insulation basic model of the HVDC transmission system 100 in operation S104 to determine an insulation cooperation withstanding voltage that is adequate for performing a function of the insulation basic model of the HVDC transmission system 100 in operation S105. Here, the insulation level calculation unit 330 performs insulation calculation of the insulation basic model of the HVDC transmission system 100 on the basis of at least one of an insulation property of the insulation basic model of the HVDC transmission system 100, a function of the insulation basic model of the HVDC transmission system 100, a statistical distribution of data of the insulation basic model of the HVDC transmission system 100, inaccuracy of input data of the insulation basic model of the HVDC transmission system 100, and a factor having an influence on an combination of components of the insulation basic model of the HVDC transmission system 100 to determine the insulation cooperation withstanding voltage that is adequate for performing the function of the insulation basis model of the HVDC transmission system 100.

The second insulation modeling unit 340 applies a difference between an actual operation state of the HVDC transmission system 100 and a state of the insulation basic model of the HVDC transmission system 100 to the insulation basic model of the HVDC transmission system 100 in operation S106 to correct the insulation basic model of the HVDC transmission system 100, thereby generating an insulation model of the HVDC transmission system 100 in operation S107. The second insulation modeling unit 340 may correct the insulation basic model of the HVDC transmission system 100 on the basis of a difference between an actual operation state of the HVDC transmission system 100 and the state of the insulation basic model of the HVDC transmission system 100 and the insulation cooperation withstanding voltage to generate an insulation model of the HVDC transmission system 100. Here, the difference between the actual operation state of the HVDC transmission system 100 and the state of the insulation basis model may include at least one of a difference in environment factor of the HVDC transmission system 100, a difference in test of the components of the HVDC transmission system 100, a deviation of a product characteristic of the HVDC transmission system 100, a difference in installation state of the HVDC transmission system 100, a difference in operation lifecycle of the HVDC transmission system 100, and a safety factor that has to be considered for safety of the HVDC transmission system 100. The insulation model of the HVDC transmission system 100 may be an insulation model that considers the environment factor and the pollution level.

The required withstanding voltage calculation unit 350 calculates a required withstanding voltage of the insulation model of the HVDC transmission system 100 in operation S109.

The reference withstanding voltage calculation unit 360 calculates a reference withstanding voltage of the insulation model of the HVDC transmission system 100 from the required withstanding voltage of the insulation model of the HVDC transmission system 100 in operation S111. The reference withstanding voltage calculation unit 360 may calculate a reference withstanding voltage of the insulation model of the HVDC transmission system 100 from the required withstanding voltage of the insulation model of the HVDC transmission system 100 on the basis of at least one of a test state, a test conversion factor, and a voltage range.

The rated insulation level calculation unit 370 calculates a rated insulation level that satisfies the reference withstanding voltage of the insulation model of the HVDC transmission system 100 in operation S113. Here, the rated insulation level may include a voltage value and distance value at at least one position of the HVDC transmission system 100.

The third insulation modeling unit 380 corrects the insulation model of the HVDC transmission system 100 on the basis of a variation in impedance in a divided section of the HVDC transmission system 100 to generate a corrected insulation model in operation S115. Here, the divided section may include at least one of a transmission-side AC part 110, a transmission-side transformation part 103, a DC power transmission part 140, a customer-side transformation part 105, a customer-side AC part 170, a transmission-side transformer part 120, a transmission-side AC-DC converter part 130, a customer-side DC-AC converter part 150, and a customer-side transformer part 160.

The insulation verification unit 390 verifies whether the corrected insulation model of the HVDC transmission system 100 satisfies the required withstanding voltage in operation S117.

According to the disclosure, the above-described method can also be embodied as processor readable codes on a processor readable recording medium. Examples of the processor readable recording medium include read-only memory (ROM), random-access memory (RAM), CD-ROMs, magnetic tapes, floppy disks, optical data storage devices, and carrier waves (such as data transmission through the Internet).

## Claims

1. An apparatus for an insulation design, which performs the insulation design of a high voltage direct current (HVDC) transmission system, the apparatus comprising:
an HVDC transmission system operation information acquisition unit (210) acquiring operation information of a former HVDC transmission system from a control part of the former HVDC transmission system, wherein the operation information of the former HVDC transmission system comprises operation state information with respect to an operation state of the former HVDC transmission system and an operation state cause information with respect to causes that have an influence on the operation state of the former HVDC transmission system;
a design specification acquisition unit (221) acquiring a design specification of the former HVDC transmission system, wherein the design specification of the former HVDC transmission system comprises design structures and component specifications of the former HVDC transmission system;
a design requirement acquisition unit (223) acquiring a design requirement of a present HVDC transmission system, wherein the design requirement of the present HVDC transmission system comprises information with respect to an available rate, information with respect to an operation time, and information with respect to a lifecycle of the present HVDC transmission system; and
an HVDC transmission system design unit (230) designing the present HVDC transmission system on the basis of the design specification of the former HVDC transmission system, the operation information of the former HVDC transmission system, and the design requirement of the present HVDC transmission system,
wherein the HVDC transmission system design unit (230) compares the operation state of the former HVDC transmission system to the design requirement of the present HVDC transmission system to correct the design specification of the former HVDC transmission system in relation to the operation state cause on the basis of the compared result and write a design specification that is adequate for the design requirement of the present HVDC transmission system,
wherein the design specification of the present HVDC transmission system comprises design structures and component specifications of the present HVDC transmission system,
wherein the former HVDC transmission system is an existing HVDC transmission system in history,
wherein, if the design requirement of the present HVDC transmission system requires a requirement that is higher than the operation state of the former HVDC transmission system as a result of the comparison, the HVDC transmission system design unit increases the design specification of the former HVDC transmission system in relation to the operation state cause by a difference between the design requirement of the present HVDC transmission system and the operation state of the former HVDC transmission system to write a design specification that is adequate for the design requirement of the present HVDC transmission system, and
wherein, if the design requirement of the present HVDC transmission system requires a requirement that is lower than the operation state of the former HVDC transmission system as the result of the comparison, the HVDC transmission system design unit (230) decreases the design specification of the former HVDC transmission system in relation to the operation state cause by a difference between the design requirement of the present HVDC transmission system and the operation state of the former HVDC transmission system to write a design specification that is adequate for the design requirement of the present HVDC transmission system.

2. The apparatus according to claim 1, wherein the HVDC transmission system design unit (230) comprises an insulation design part (300) that performs an insulation design of the present HVDC transmission system on the basis of the operation information of the former HVDC transmission system and the design requirement of the present HVDC transmission system.

3. The apparatus according to claim 2, wherein the insulation design part (300) comprises:
a first insulation modeling unit (320) modeling the present HVDC transmission system on the basis of an overvoltage and rated voltage of the present HVDC transmission system to generate an insulation basis model of the HVDC transmission system;
an insulation level calculation unit (330) performing insulation calculation of the insulation basic model to determine an insulation cooperation withstanding voltage that is adequate for performing a function of the insulation basis model of the present HVDC transmission system;
a second insulation modeling unit (340) correcting the insulation basis model of the present HVDC transmission system on the basis of the insulation cooperation withstanding voltage to generate an insulation model of the present HVDC transmission system; and
a rated insulation level calculation unit (370) calculating a rated insulation level that satisfies a reference withstanding voltage of the insulation model of the present HVDC transmission system.

4. The apparatus according to claim 3, further comprising:
a third insulation modeling unit (380) correcting the insulation model of the present HVDC transmission system on the basis of a variation in impedance in a divided section of the present HVDC transmission system to generate a corrected insulation model; and
an insulation verification unit (390) verifying whether the corrected insulation model of the present HVDC transmission system satisfies the required withstanding voltage.

5. The apparatus according to claim 1, wherein the HVDC transmission system design unit (230) comprises:
a DC transformation part design part (233) designing a structure of a DC transformation part of the present HVDC transmission system on the basis of the operation information of the former HVDC transmission system and the design requirement of the present HVDC transmission system; and
a DC transformation part component specification determination part (234) determining specifications of components within the DC transmission part of the present HVDC transmission system on the basis of the operation information of the former HVDC transmission system and the design requirement of the present HVDC transmission system.

6. The apparatus according to claim 1, wherein the HVDC transmission system design unit (230) comprises:
a DC power transmission part design part (235) designing a structure of a DC power transmission part of the present HVDC transmission system on the basis of the operation information of the former HVDC transmission system and the design requirement of the present HVDC transmission system; and
a DC power transmission part component specification determination part (234) determining specifications of components within the DC power transmission part of the present HVDC transmission system on the basis of the operation information of the former HVDC transmission system and the design requirement of the present HVDC transmission system.

7. The apparatus according to claim 1, wherein the HVDC transmission system design unit (230) comprises:
an AC part design part (231) designing a structure of an AC part of the present HVDC transmission system on the basis of the operation information of the former HVDC transmission system and the design requirement of the present HVDC transmission system; and
an AC part component specification determination part (232) determining specifications of components within the AC part of the present HVDC transmission system on the basis of the operation information of the former HVDC transmission system and the design requirement of the present HVDC transmission system.

## Patentansprüche

1. Vorrichtung für eine Isolationskonstruktion, die die Isolationskonstruktion eines Hochspannungs-Gleichstromübertragungssystems (HGÜ) durchführt, die Vorrichtung umfassend:
eine Betriebsinformationserfassungseinheit (210) für ein HGÜ-System, die Betriebsinformationen eines ehemaligen HGÜ-Systems von einem Steuerteil des ehemaligen HGÜ-Systems erfasst, wobei die Betriebsinformationen des ehemaligen HGÜ-Systems Betriebszustandsinformationen in Bezug auf einen Betriebszustand des ehemaligen HGÜ-Systems und eine Betriebszustandsursacheninformation in Bezug auf Ursachen umfassen, die einen Einfluss auf den Betriebszustand des ehemaligen HGÜ-Systems haben;
eine Konstruktionsspezifikationserfassungseinheit (221), die eine Konstruktionsspezifikation des ehemaligen HGÜ-Systems erfasst, wobei die Konstruktionsspezifikation des ehemaligen HGÜ-Systems Konstruktionsstrukturen und Komponentenspezifikationen des ehemaligen HGÜ-Systems umfasst;
eine Konstruktionsanforderungserfassungseinheit (223), die eine Design-Anforderung eines vorliegenden HGÜ-Systems erwirbt, wobei die Design-Anforderung des vorliegenden HGÜ-Systems Informationen in Bezug auf eine verfügbare Rate, Informationen in Bezug auf eine Betriebszeit und Informationen in Bezug auf einen Lebenszyklus des vorliegenden HGÜ-Systems umfasst; und
eine Konstruktionseinheit des HGÜ-Systems (230), die das vorliegende HGÜ-System basierend auf der Konstruktionsspezifikation des ehemaligen HGÜ-Systems, der Betriebsinformationen des ehemaligen HGÜ-Systems und der Konstruktionsanforderungen des vorliegenden HGÜ-Systems entwirft,
wobei die Konstruktionseinheit des HGÜ-Systems (230) den Betriebszustand des ehemaligen HGÜ-Systems mit der Konstruktionsanforderung des vorliegenden HGÜ-Systems vergleicht, um die Konstruktionsspezifikation des ehemaligen HGÜ-Systems in Bezug auf die Betriebszustandsursache basierend auf dem verglichenen Ergebnis zu korrigieren und eine Konstruktionsspezifikation zu schreiben, die für die Konstruktionsanforderung des vorliegenden HGÜ-Systems ausreichend ist,
wobei die Konstruktionsspezifikation des vorliegenden HGÜ-Systems Konstruktionsstrukturen und Komponentenspezifikationen des vorliegenden HGÜ-Systems umfasst,
wobei das ehemalige HGÜ-System ein bestehendes HGÜ-System in der Geschichte ist,
wobei, wenn die Konstruktionsanforderung des vorliegenden HGÜ-Systems eine Anforderung erfordert, die infolge des Vergleichs höher ist als der Betriebszustand des ehemaligen HGÜ-Systems, die Konstruktionseinheit des HGÜ-Systems die Konstruktionsspezifikation des ehemaligen HGÜ-Systems in Bezug auf den Betriebszustand erhöht, der durch eine Differenz zwischen der Konstruktionsanforderung des vorliegenden HGÜ-Systems und dem Betriebszustand des ehemaligen HGÜ-Systems verursacht wird, um eine Konstruktionsspezifikation zu schreiben, die für die Konstruktionsanforderung des vorliegenden HGÜ-Systems angemessen ist, und
wobei, wenn die Konstruktionsanforderung des vorliegenden HGÜ-Systems eine Anforderung erfordert, die infolge des Vergleichs niedriger ist als der Betriebszustand des ehemaligen HGÜ-Systems, die Konstruktionseinheit des HGÜ-Systems (230) die Konstruktionsspezifikation des ehemaligen HGÜ-Systems in Bezug auf den Betriebszustand verringert, der durch eine Differenz zwischen der Konstruktionsanforderung des vorliegenden HGÜ-Systems und dem Betriebszustand des ehemaligen HGÜ-Systems verursacht wird, um eine Konstruktionsspezifikation zu schreiben, die für die Konstruktionsanforderung des vorliegenden HGÜ-Systems ausreichend ist.

2. Vorrichtung nach Anspruch 1, wobei die Konstruktionseinheit des HGÜ-Systems (230) ein Isolationskonstruktionsteil (300) umfasst, das eine Isolationskonstruktion des vorliegenden HGÜ-Systems basierend auf den Betriebsinformationen des ehemaligen HGÜ-Systems und der Konstruktionsanforderungen des vorliegenden HGÜ-Systems durchführt.

3. Vorrichtung nach Anspruch 2, das Isolationskonstruktionsteil (300) umfassend:
eine erste Isolationsmodellierungseinheit (320), die das vorliegende HGÜ-System basierend auf einer Überspannung und Nennspannung des vorliegenden HGÜ-Systems modelliert, um ein Isolationsbasismodell des HGÜ-Systems zu erzeugen;
eine Isolationsgrad-Berechnungseinheit (330), die eine Isolationsberechnung des Isolationsbasismodells durchführt, um eine Isolationskooperation zu bestimmen, die ausreichend ist, um eine Funktion des Isolationsbasismodells des vorliegenden HGÜ-Systems auszuführen;
eine zweite Isolationsmodellierungseinheit (340), die das Isolationsbasismodell des vorliegenden HGÜ-Systems basierend auf der Isolationskooperation gegen Spannungsfestigkeit korrigiert, um ein Isolationsmodell des vorliegenden HGÜ-Systems zu erzeugen; und
eine Berechnungseinheit für den Bemessungsisolationsgrad (370), die einen Bemessungsisolationsgrad berechnet, der einer Referenz-Stehwechselspannung des Isolationsmodells des vorliegenden HGÜ-Systems entspricht.

4. Vorrichtung nach Anspruch 3, ferner umfassend:
eine dritte Isolationsmodellierungseinheit (380), die das Isolationsmodell des vorliegenden HGÜ-Systems basierend auf einer Impedanzschwankung in einem geteilten Abschnitt des vorliegenden HGÜ-Systems korrigiert, um ein korrigiertes Isolationsmodell zu erzeugen; und
eine Isolationsverifikationseinheit (390), die überprüft, ob das korrigierte Isolationsmodell des vorliegenden HGÜ-Systems der erforderliche Stehspannung entspricht.

5. Vorrichtung nach Anspruch 1, wobei die Konstruktionseinheit des HGÜ-Systems (230) umfasst:
einen Gleichstrom-Transformationsteil-Konstruktionsteil (233), der eine Struktur eines Gleichstrom-Transformationsteils des vorliegenden HGÜ-Systems basierend auf den Betriebsinformationen des ehemaligen HGÜ-Systems und der Konstruktionsanforderung des vorliegenden HGÜ-Systems entwirft; und
einen Gleichstrom-Transformationsteil-Komponenten-Spezifikations-Bestimmungsteil (234), der Spezifikationen von Komponenten innerhalb des Gleichstrom-Übertragungsteils des vorliegenden HGÜ-Systems basierend auf den Betriebsinformationen des ehemaligen HGÜ-Systems und den Konstruktionsanforderungen des vorliegenden HGÜ-Systems bestimmt.

6. Vorrichtung nach Anspruch 1, wobei die Konstruktionseinheit des HGÜ-Systems (230) umfasst:
ein Gleichstrom-Übertragungsteil-Konstruktionsteil (235), das eine Struktur eines Gleichstrom-Übertragungsteils des vorliegenden HGÜ-Systems basierend auf den Betriebsinformationen des ehemaligen HGÜ-Systems und den Konstruktionsanforderungen des vorliegenden HGÜ-Systems entwirft; und
ein Gleichstrom-Übertragungsteil-Komponentenspezifikations-Bestimmungsteil (234), das Spezifikationen von Komponenten innerhalb des Gleichstrom-Übertragungsteils des vorliegenden HGÜ-Systems basierend auf den Betriebsinformationen des ehemaligen HGÜ-Systems und den Konstruktionsanforderungen des vorliegenden HGÜ-Systems bestimmt.

7. Vorrichtung nach Anspruch 1, wobei die Konstruktionseinheit des HGÜ-Systems (230) umfasst:
ein Wechselstromteil-Konstruktionsteil (231), das eine Struktur eines Wechselstromteils des vorliegenden HGÜ-Systems basierend auf den Betriebsinformationen des ehemaligen HGÜ-Systems und der Konstruktionsanforderungen des vorliegenden HGÜ-Systems entwirft;
und ein Wechselstrom-Komponentenspezifikations-Bestimmungsteil (232), das Spezifikationen von Komponenten innerhalb des Wechselstromteils des vorliegenden HGÜ-Systems basierend auf den Betriebsinformationen des ehemaligen HGÜ-Systems und den Konstruktionsanforderungen des vorliegenden HGÜ-Systems bestimmt.

## Revendications

1. Appareil pour une conception d'isolation, qui réalise la conception d'isolation d'un système de transport d'énergie électrique en courant continu à haute tension (HVDC), l'appareil comprenant :
une unité d'acquisition d'informations de fonctionnement de système de transport d'énergie électrique HVDC (210) acquérant des informations de fonctionnement d'un système de transport d'énergie électrique HVDC antérieur à partir d'une partie de commande du système de transport d'énergie électrique HVDC antérieur, dans lequel les informations de fonctionnement du système de transport d'énergie électrique HVDC antérieur comprend des informations d'état de fonctionnement en rapport avec un état de fonctionnement du système de transport d'énergie électrique HVDC antérieur et des informations de cause d'état de fonctionnement en rapport avec des causes qui ont une influence sur l'état de fonctionnement du système de transport d'énergie électrique HVDC antérieur ;
une unité d'acquisition de spécification de conception (221) acquérant une spécification de conception du système de transport d'énergie électrique HVDC antérieur, dans lequel la spécification de conception du système de transport d'énergie électrique HVDC antérieur comprend des spécifications de structures et de composant de conception du système de transport d'énergie électrique HVDC antérieur ;
une unité d'acquisition d'exigence de conception (223) acquérant une exigence de conception d'un système de transport d'énergie électrique HVDC présent, dans lequel l'exigence de conception du système de transport d'énergie électrique HVDC présent comprend des informations en rapport avec un débit disponible, des informations en rapport avec une durée de fonctionnement et des informations en rapport avec un cycle de vie du système de transport d'énergie électrique HVDC présent ; et
une unité de conception de système de transport d'énergie électrique HVDC (230) concevant le système de transport d'énergie électrique HVDC présent sur la base de la spécification de conception du système de transport d'énergie électrique HVDC antérieur, des informations de fonctionnement du système de transport d'énergie électrique HVDC antérieur et de l'exigence de conception du système de transport d'énergie électrique HVDC présent,
dans lequel l'unité de conception de système de transport d'énergie électrique HVDC (230) compare l'état de fonctionnement du système de transport d'énergie électrique HVDC antérieur à l'exigence de conception du système de transport d'énergie électrique HVDC présent pour corriger la spécification de conception du système de transport d'énergie électrique HVDC antérieur en lien avec la cause d'état de fonctionnement sur la base du résultat comparé et écrire une spécification de conception qui est adéquate pour l'exigence de conception du système de transport d'énergie électrique HVDC présent,
dans lequel la spécification de conception du système de transport d'énergie électrique HVDC présent comprend des spécifications de structures et de composant du système de transport d'énergie électrique HVDC présent,
dans lequel le système de transport d'énergie électrique HVDC antérieur est un système de transport d'énergie électrique HVDC existant dans l'historique,
dans lequel, si l'exigence de conception du système de transport d'énergie électrique HVDC présent requiert une exigence qui est supérieure à l'état de fonctionnement du système de transport d'énergie électrique HVDC antérieur en tant que résultat de la comparaison, l'unité de conception de système de transport d'énergie électrique HVDC augmente la spécification de conception du système de transport d'énergie électrique HVDC antérieur en lien avec la cause d'état de fonctionnement d'une différence entre l'exigence de conception du système de transport d'énergie électrique HVDC présent et l'état de fonctionnement du système de transport d'énergie électrique HVDC antérieur pour écrire une spécification de conception qui est adéquate pour l'exigence de conception du système de transport d'énergie électrique HVDC présent, et
dans lequel, si l'exigence de conception du système de transport d'énergie électrique HVDC présent requiert une exigence qui est inférieure à l'état de fonctionnement du système de transport d'énergie électrique HVDC antérieur en tant que résultat de la comparaison, l'unité de conception de système de transport d'énergie électrique HVDC (230) abaisse la spécification de conception du système de transport d'énergie électrique HVDC antérieur en lien avec la cause d'état de fonctionnement d'une différence entre l'exigence de conception du système de transport d'énergie électrique HVDC présent et l'état de fonctionnement du système de transport d'énergie électrique HVDC antérieur pour écrire une spécification de conception qui est adéquate pour l'exigence de conception du système de transport d'énergie électrique HVDC présent.

2. Appareil selon la revendication 1, dans lequel l'unité de conception de système de transport d'énergie électrique HVDC (230) comprend une partie de conception d'isolation (300) qui réalise une conception d'isolation du système de transport d'énergie électrique HVDC présent sur la base des informations de fonctionnement du système de transport d'énergie électrique HVDC antérieur et de l'exigence de conception du système de transport d'énergie électrique HVDC présent.

3. Appareil selon la revendication 2, dans lequel la partie de conception d'isolation (300) comprend :
une première unité de modélisation d'isolation (320) modélisant le système de transport d'énergie électrique HVDC présent sur la base d'une surtension et d'une tension nominale du système de transport d'énergie électrique HVDC présent pour générer un modèle de base d'isolation du système de transport d'énergie électrique HVDC ;
une unité de calcul de niveau d'isolation (330) réalisant un calcul d'isolation du modèle de base d'isolation pour déterminer une tension de tenue de coopération d'isolation qui est adéquate pour réaliser une fonction du modèle de base d'isolation du système de transport d'énergie électrique HVDC présent ;
une deuxième unité de modélisation d'isolation (340) corrigeant le modèle de base d'isolation du système de transport d'énergie électrique HVDC présent sur la base de la tension de tenue de coopération d'isolation pour générer un modèle d'isolation du système de transport d'énergie électrique HVDC présent ; et
une unité de calcul de niveau d'isolation nominal (370) calculant un niveau d'isolation nominal qui respecte une tension de tenue de référence du modèle d'isolation du système de transport d'énergie électrique HVDC présent.

4. Appareil selon la revendication 3, comprenant en outre :
une troisième unité de modélisation d'isolation (380) corrigeant le modèle d'isolation du système de transport d'énergie électrique HVDC présent sur la base d'une variation d'impédance d'une section divisée du système de transport d'énergie électrique HVDC présent pour générer un modèle d'isolation corrigé ; et
une unité de vérification d'isolation (390) vérifiant si le modèle d'isolation corrigé du système de transport d'énergie électrique HVDC présent respecte la tension de tenue requise.

5. Appareil selon la revendication 1, dans lequel l'unité de conception de système de transport d'énergie électrique HVDC (230) comprend :
une partie de conception de partie de transformation CC (233) concevant une structure d'une partie de transformation CC du système de transport d'énergie électrique HVDC présent sur la base des informations de fonctionnement du système de transport d'énergie électrique HVDC antérieur et de l'exigence de conception du système de transport d'énergie électrique HVDC présent ; et
une partie de détermination de spécification de composant de partie de transformation CC (234) déterminant des spécifications de composants dans la partie de transport d'énergie CC du système de transport d'énergie électrique HVDC présent sur la base des informations de fonctionnement du système de transport d'énergie électrique HVDC antérieur et de l'exigence de conception du système de transport d'énergie électrique HVDC présent.

6. Appareil selon la revendication 1, dans lequel l'unité de conception de système de transport d'énergie électrique HVDC (230) comprend :
une partie de conception de partie de transport d'énergie CC (235) concevant une structure d'une partie de transport d'énergie CC du système de transport d'énergie électrique HVDC présent sur la base des informations de fonctionnement du système de transport d'énergie électrique HVDC antérieur et de l'exigence de conception du système de transport d'énergie électrique HVDC présent ; et
une partie de détermination de spécification de composant de partie de transport d'énergie CC (234) déterminant des spécifications de composants dans la partie de transport d'énergie CC du système de transport d'énergie électrique HVDC présent sur la base des informations de fonctionnement du système de transport d'énergie électrique HVDC antérieur et de l'exigence de conception du système de transport d'énergie électrique HVDC présent.

7. Appareil selon la revendication 1, dans lequel la partie de conception de système de transport d'énergie électrique HVDC (230) comprend :
une partie de conception de partie CA (231) concevant une structure d'une partie CA du système de transport d'énergie électrique HVDC présent sur la base des informations de fonctionnement du système de transport d'énergie électrique HVDC antérieur et de l'exigence de conception du système de transport d'énergie électrique HVDC présent ; et
une partie de détermination de spécification de composant de partie CA (232) déterminant des spécifications de composants dans la partie CA du système de transport d'énergie électrique HVDC présent sur la base des informations de fonctionnement du système de transport d'énergie électrique HVDC antérieur et de l'exigence de conception du système de transport d'énergie électrique HVDC présent.
